(19) Europäisches Patentamt
European Patent Office
Office européen des brevets

(11) EP 3 960 325 A1

(12) **EUROPEAN PATENT APPLICATION**
published in accordance with Art. 153(4) EPC

(43) Date of publication:
**02.03.2022 Bulletin 2022/09**

(21) Application number: **20794658.3**

(22) Date of filing: **21.04.2020**

(51) International Patent Classification (IPC):
***B21D 47/04*** (2006.01) ***B21D 53/00*** (2006.01)
***B29C 45/14*** (2006.01) ***H05K 5/02*** (2006.01)

(52) Cooperative Patent Classification (CPC):
**B21D 47/04; B21D 53/00; B29C 45/14; H05K 5/02**

(86) International application number:
**PCT/JP2020/017156**

(87) International publication number:
**WO 2020/218277 (29.10.2020 Gazette 2020/44)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.04.2019 JP 2019080746**

(71) Applicant: **Mitsui Chemicals, Inc.**
**Tokyo 105-7122 (JP)**

(72) Inventors:
- **TOMINAGA, Takahiro**
  **Sodegaura-shi**
  **Chiba 299-0265 (JP)**
- **MORIMOTO, Kai**
  **Sodegaura-shi**
  **Chiba 299-0265 (JP)**
- **KIMURA, Kazuki**
  **Sodegaura-shi**
  **Chiba 299-0265 (JP)**
- **MAKIGUCHI, Wataru**
  **Sodegaura-shi**
  **Chiba 299-0265 (JP)**
- **UEDA, Kosuke**
  **Sodegaura-shi**
  **Chiba 299-0265 (JP)**

(74) Representative: **J A Kemp LLP**
**80 Turnmill Street**
**London EC1M 5QU (GB)**

(54) **ELECTRONIC EQUIPMENT HOUSING, METHOD FOR MANUFACTURING SAME, AND METAL-RESIN COMPOSITE**

(57) Provided is an electronic device housing including a metal member and a plastic antenna cover that are joined and integrated by insert molding. In this electronic device housing, the plastic antenna cover is a molded product of a thermoplastic resin composition containing a thermoplastic polyester resin having a melting point Tm equal to or higher than 250°C.

Fig. 2

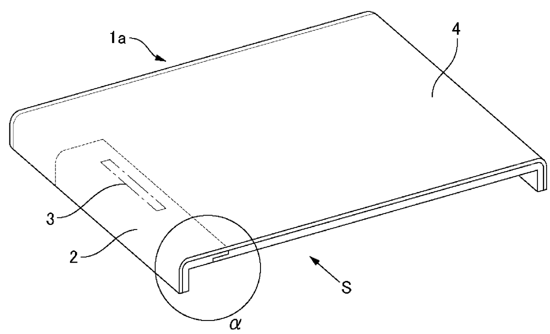


EP 3 960 325 A1

## Description

### TECHNICAL FIELD

The present invention relates to an electronic device housing, a manufacturing method of the same, and a metal-resin composite.

### BACKGROUND ART

In recent years, electronic devices such as notebook PCs (notebook computers) having a wireless LAN (local area network) function and various mobile devices have become rapidly widespread.
In a notebook PC having a wireless LAN function, from the viewpoint of portability and prevention of damage at the time of dropping, it is desirable that an antenna element be embedded in a housing body instead of protruding from the body of the notebook PC. The same applies to electronic devices other than the notebook PC.
Light metals such as magnesium alloys or aluminum alloys which are frequently used as housing materials have properties of hindering the transmission of radio waves. Therefore, in a case where a metal housing is used as a housing of an electronic device equipped with a built-in antenna, for example, a structure is adopted in which an opening portion is formed at a site corresponding to the antenna element of the housing, a plastic antenna cover is put on the opening portion, and the plastic portion and the metal member are fastened together (regarding such a structure, for example, see Patent Documents 1 and 2). As the fastening method, mechanical engagement by rivets and the like are considered.
However, in the case of mechanical engagement, a gap may occur in the engagement portion, or the engagement portion may loosen due to long-term use, which may sometimes adversely affect the overall strength of the electronic device.

### RELATED DOCUMENT

### PATENT DOCUMENT

[Patent Document 1] Japanese Unexamined Patent Publication No. 2010-282493
[Patent Document 2] Japanese Unexamined Patent Publication No. 2011-156587

### SUMMARY OF THE INVENTION

### TECHNICAL PROBLEM

As a method different from the mechanical engagement, a method of joining and integrating the metal housing and the plastic antenna cover by insert molding is considered. It is considered that the insert molding can clear up the aforementioned problem of the mechanical engagement. Furthermore, insert molding is a method having excellent productivity, and makes a junction having excellent strength and a junction interface having excellent watertightness.
However, according to a preliminary study by the inventors of the present invention, in an annealing step for removing the residual stress generated by a high temperature treatment performed on the metal member side during insert molding, the plastic material is deformed or deteriorates, which leads to a problem of decrease in joining strength.
Particularly, recently, for the purpose of weight reduction, lightweight magnesium alloys have been more increasingly used as metal members. However, according to the knowledge of the inventors of the present invention and the like, in order to be sufficiently annealed, the magnesium alloys need to be treated at a relatively high temperature, and thus the above problem becomes more obvious.
The present invention has been made to solve the above problem. An object of the present invention is to provide an electronic device housing which has sufficient heat resistance against annealing after insert molding and consists of a metal member and a plastic antenna cover that are joined and integrated.

### SOLUTION TO PROBLEM

In order to achieve the above object, the inventors of the present invention conducted intensive studies. As a result, the inventors have accomplished the present invention described below.
The present invention is as follows.

1. An electronic device housing including a metal member, and a plastic antenna cover, in which the metal member and the plastic antenna cover are joined and integrated by insert molding, and
the plastic antenna cover is a molded product of a thermoplastic resin composition containing a thermoplastic polyester resin having a melting point Tm equal to or higher than 250°C.
2. The electronic device housing described in 1.,
in which a crystallinity of the plastic antenna cover determined by a wide-angle X-ray diffraction profile is equal to or less than 50%.
3. The electronic device housing described in 1. or 2.,
in which the thermoplastic polyester resin contains a structural unit derived from an aromatic dicarboxylic acid-based monomer and a structural unit derived from a diol having an alicyclic skeleton.
4. The electronic device housing described in 3.,
in which the aromatic dicarboxylic acid-based monomer is terephthalic acid.
5. The electronic device housing described in any one of 1. to 4.,
in which a content of the thermoplastic polyester resin (P) in the thermoplastic resin composition is 40% to 80% by mass.
6. The electronic device housing described in any one of 1. to 5.,
in which the thermoplastic resin composition contains other polymer components (Q) in addition to the thermoplastic polyester resin (P).
7. The electronic device housing described in 6.,
in which a content of the other polymer components (Q) in the thermoplastic resin composition is 1% to 20% by mass.
8. The electronic device housing described in 6. or 7.,
in which the other polymer components (Q) include a copolymer (D) having a structural unit derived from an olefin and a structural unit having a cyclic oxyhydrocarbon structure.
9. The electronic device housing described in 8.,
in which the other polymer components (Q) further include one or more polymers (E) selected from the group consisting of an ethylene·$\alpha$-olefin copolymer (E1), polybutylene terephthalate (E2), polycarbonate (E3), and isophthalic acid-modified polycyclohexylenedimethylene terephthalate (E4).
10. The electronic device housing described in 9.,
in which a mass ratio of the copolymer (D) : the polymer (E) is 1:0.1 to 1:0.5.
11. The electronic device housing described in 9. or 10.,
in which a mass ratio of the copolymer (D) : the polybutylene terephthalate (E2), the polycarbonate (E3) and the isophthalic acid-modified polycyclohexylenedimethylene terephthalate (E4) is 1:1 to 1:10.
12. The electronic device housing described in any one of 1. to 11., in which the metal member is one kind selected from the group consisting of magnesium or a magnesium alloy, aluminum or an aluminum alloy, titanium or a titanium alloy, and copper or a copper alloy.
13. The electronic device housing described in any one of 1. to 12., in which an anticorrosive surface modifying film is formed on at least a portion of a surface of the metal member, the portion to which the plastic antenna cover is not joined.
14. A manufacturing method of a electronic device housing, including:

a step 1 of preparing a metal member,
a step 2 of joining and integrating the metal member and a thermoplastic resin composition containing a thermoplastic polyester resin having a melting point Tm equal to or higher than 250°C by insert molding so as to manufacture a dissimilar material joined body consisting of the metal member and a plastic antenna cover,
a step 3 of annealing the dissimilar material joined body at 180°C to 350°C for 1 to 30 minutes so as to convert the dissimilar material joined body into a heat-treated dissimilar material joined body,
a step 4 of performing an oxidation treatment on a surface of at least a portion of the metal member of the heat-treated dissimilar material joined body, the portion to which the plastic antenna cover is not joined, by at least one method selected from the group consisting of anodic oxidation, micro-arc oxidation, and a chemical conversion treatment so as to obtain a surface-modified dissimilar material joined body, and
a step 5 of forming a coating film layer in at least a region of the surface-modified dissimilar material joined body, the region including a junctional portion between the metal member and the plastic antenna cover, in which the steps 1 to 5 are performed in this order.

15. A metal-resin composite including a magnesium alloy member, and a resin member, in which the magnesium alloy member and the resin member are joined and integrated, and

the resin member is a molded product of a thermoplastic resin composition containing a thermoplastic polyester resin having a melting point Tm equal to or higher than 250°C.

ADVANTAGEOUS EFFECTS OF INVENTION

According to the present invention, there is provided an electronic device housing which has sufficient heat resistance against annealing after insert molding and includes a metal member and a plastic antenna cover that are joined and integrated.

BRIEF DESCRIPTION OF THE DRAWINGS

Fig. 1 is an external view of a notebook PC which is an example of an electronic device.
Fig. 2 is a schematic sectional view of a display unit of the notebook PC taken along the line X-X in Fig. 1.
Fig. 3 is a view schematically showing a structure that can be seen in a case where the portion surrounded by the circle $\alpha$ in Fig. 2 is enlarged and viewed from the S direction.
Fig. 4 is a view for illustrating "dissimilar material joined body A" in Examples.
Fig. 5 is a view for illustrating "dissimilar material joined body B" in Examples.

DESCRIPTION OF EMBODIMENTS

Hereinafter, embodiments of the present invention will be described using drawings.
In all drawings, the same constituents are marked with the same reference signs and may not be repeatedly described as appropriate.
The drawings are merely schematic views. The dimensional ratio in the drawings does not always match the dimensional ratio of the actual article.
In the present specification, unless otherwise specified, "to" in the description of a numerical range represents "equal to or greater than and equal to or less than". For example, "100°C to 200°C" means "equal to or higher than 100°C and equal to or lower than 200°C".

<Electronic device housing>

Fig. 1 is an external view of a notebook PC (notebook PC 1) which is an example of an electronic device.
The notebook PC 1 is constituted with a body unit (palm rest portion) 1a and a display unit 1b.
The body unit 1a includes a flat box-shaped housing that houses main constituents such as a printed wiring board on which CPU is mounted and a hard disk drive device.
The display unit 1b is usually connected to the body unit 1a via a hinge mechanism. A liquid crystal display panel and the like are housed in the flat box-shaped housing of the display unit 1b.
In the display unit 1b, a metal member 4 and a plastic antenna cover 2 are joined and integrated by insert molding at the portion of the broken line (shown in Fig. 1). That is, it can be said that the display unit 1b is a dissimilar material joined body consisting of a metal member and a plastic antenna cover.
Fig. 2 is a schematic sectional view of the display unit 1b taken along the line X-X in Fig. 1.
Fig. 3 is a view schematically showing a structure that can be seen in a case where the portion surrounded by the circle $\alpha$ in Fig. 2 is enlarged and viewed from the S direction. It can be said that Fig. 3 is an enlarged view of a part of a section of the display unit 1b taken along the line X-X in Fig. 1.
The plastic antenna cover 2 is a molded product of a thermoplastic resin composition containing a thermoplastic polyester resin (P) having a melting point Tm equal to or higher than 250°C. Therefore, the plastic antenna cover 2 has sufficient heat resistance against annealing after insert molding. That is, deformation or deterioration of the plastic antenna cover 2 is suppressed. These properties are advantageous particularly in a case where the metal member 4 is a magnesium alloy that needs to be annealed at a relatively high temperature.
Furthermore, because the plastic antenna cover 2 is a molded product of the thermoplastic resin composition containing the thermoplastic polyester resin (P) having a melting point Tm equal to or higher than 250°C, in a case where a coating film layer 5 is provided on the surface of the dissimilar material joined body consisting of the metal member 4 and the plastic antenna cover 2 that are joined together, it is possible to obtain an advantage of preventing the occurrence of a step or minimizing the size of a step in a junction 7 and the vicinity thereof (indicated by the point P in Fig. 3).
Specifically, in a case where the metal member and the plastic antenna cover are joined and integrated by insert molding using an appropriate mold so as to manufacture a dissimilar material joined body, and then the dissimilar

material joined body is annealed at a high temperature so as to eliminate the deformation that occurs mainly on the side of the metal member during the manufacturing of the dissimilar material joined body, the deformation of plastic can be reduced, and it is easy to avoid the occurrence of a gap in the junction 7 (because the plastic antenna cover is heat-resistant plastic containing a thermoplastic polyester resin having a Tm equal to or higher than 250°C) . As a result, even though the coating film layer 5 is formed on the surface of the dissimilar material joined body, the occurrence of a step can be suppressed, and an electronic device housing having excellent design is provided.

Particularly, in the present embodiment, even though the dissimilar material joined body consisting of the metal member 4 and the plastic antenna cover 2 that are joined together is first subjected to an oxidation treatment using a chemical liquid or the like for surface modification, and then the coating film layer 5 is provided on the surface of the dissimilar material joined body, it is possible to suppress the occurrence of a step at the junction interface (junction 7) and the vicinity thereof.

In a case where joining at the junction interface (junction 7) is not tight enough, the chemical liquid may permeate into the junction 7 during the surface modification, and the junction 7 may partially fracture. Furthermore, in a case where the plastic antenna cover 2 is deformed by annealing, a gap occurs at the junction 7, and the chemical liquid more easily permeates into the junction 7. Consequently, a step (depression) tends to occur in the vicinity of the point P of the coating film layer 5. However, in the present embodiment, the joining force at the junction 7 can be sufficiently strengthened, and deformation·deterioration of the plastic antenna cover 2 caused by annealing are suppressed. Accordingly, the permeation of the chemical liquid is suppressed. As a result, a step (depression) hardly occurs in the vicinity of the point P of the coating film layer 5.

In Fig. 3, the L-shaped plastic antenna cover 2 and the metal member 4 are joined by a half-lap joint structure. However, this structure is not particularly limited. Any of joint structures such as a butt joint, a miter joint, a V joint, a tongue-and-groove joint, and a shiplap joint can be adopted.

In order to prevent the corrosion of the metal member 4, an anticorrosive surface modifying film may be formed on a part or the entirety of the surface of the metal member 4, more specifically, on at least a portion of the metal member 4 to which the plastic antenna cover 2 is not joined. The surface modifying film can be formed, for example, by an oxidation treatment method such as anodic oxidation, micro-arc oxidation, or a chemical conversion treatment that will be described later. In other words, the surface modifying film is, for example, an oxide film.

In addition, for the purpose of improving design, it is preferable that the coating film layer 5 be formed by coating on at least a part or the entirety of the side of an outer surface between an inner surface and an outer surface. As described above, in the vicinity of the point P, no step occurs or the size of a step can be minimized even though it occurs. Therefore, a step hardly occurs on the surface of the coating film layer 5 as well. In view of improving design, this characteristic is preferable.

An antenna element 3 is disposed in the plastic antenna cover 2. In Figs. 1 and 2, only one antenna element 3 is illustrated for convenience. However, in an actual notebook PC, a plurality of antenna elements 3 may be arranged at the peripheral edge of the display unit 1b.

Hereinafter, the metal member 4 which is a constituent member of the electronic device housing of the present embodiment, the thermoplastic resin composition constituting the plastic antenna cover 2, the coating film layer 5, and the like will be sequentially described.

(Metal member)

As the metal member 4, metals that can be joined to a thermoplastic resin composition by insert molding and demonstrate desired performance as an electronic device housing can be used without limitations.

Specific examples of materials of the metal member 4 include aluminum, iron, copper, magnesium, tin, nickel, zinc, alloys of these, and the like.

Among these, magnesium or a magnesium alloy, aluminum or an aluminum alloy, titanium or a titanium alloy, and copper or a copper alloy are preferable, and magnesium or a magnesium-based alloy is more preferable, because these contribute to the reduction of weight of the metal member 4 and the electronic device housing.

Examples of magnesium-based alloys include alloys of magnesium with elements such as aluminum, manganese, silicon, zinc, zirconium, copper, lithium, thorium, silver, and yttrium, and the like.

As described at the beginning, in order to be sufficiently annealed, magnesium alloys need to be treated at a relatively high temperature. In the present embodiment, because the plastic antenna cover 2 has sufficient heat resistance, even though annealing is performed at a relatively high temperature, the phenomenon such as reduction of joining strength or cracking of the junction 7 is suppressed.

The shape of the metal member 4 is not particularly limited. The shape can be randomly determined depending on the type or use of the electronic device housing. The shape includes a planar shape, a curved plate shape, a rod shape, a cylindrical shape, an amorphous shape, and the like. However, it is preferable that the site of the metal member 4 that comes into contact with the thermoplastic resin composition (hereinafter, also simply called "contact site") be planar.

The metal member 4 having a desired shape can be prepared by known metal processing methods such as thinning processing including plastic working by a press, punching, cutting, polishing, electric discharge machining, and the like.

At least the junction 7 of the surface of the metal member 4 that is joined to the plastic antenna cover 2 may be surface-treated by any method. From the viewpoint of further increasing the joining strength between the metal member 4 and the thermoplastic resin composition, it is preferable that the junction 7 between the metal member 4 and the plastic antenna cover 2 be roughened. Specifically, the junction 7 between the metal member 4 and the plastic antenna cover 2 preferably has a fine irregular structure including of projections arranged at a periodic interval of 5 nm to 500 $\mu$m.

"Periodic interval" described above is the average distance between one projection and the neighboring projection within the surface of the fine irregularities. The periodic interval can be determined from a photograph captured, for example, with an electron microscope or a laser microscope. Specifically, the contact site of the metal member 4 is imaged using an electron microscope or a laser microscope, 50 projections are randomly selected from the obtained photograph, and the distance between each of the projections and the neighboring projection is measured. Then, the arithmetic mean of the distance between each of the 50 projections and the neighboring projection is calculated, and the obtained value is adopted as the periodic interval.

In addition, the periodic interval can be said to be a value corresponding to the average length RSm of the roughness curve elements defined in JIS B 0601.

The periodic interval is preferably 10 nm to 300 $\mu$m, and more preferably 20 nm to 200 $\mu$m. In a case where the periodic interval is equal to or more than 10 nm, the thermoplastic resin composition can sufficiently enter the depressions within the surface of the fine irregularities, and the joining strength between the metal member and the thermoplastic resin composition can be further improved. Furthermore, in a case where the periodic interval is equal to or less than 300 $\mu$m, it is possible to suppress the occurrence of a gap at the metal-resin interface in the obtained dissimilar material joined body. Therefore, it is possible to efficiently prevent impurities such as water from permeating into the gap, which leads to the suppression of strength reduction that occurs, for example, in a case where the dissimilar material joined body is used at high temperature·high humidity.

The average hole depth of the depressions in the fine irregular structure is preferably 5 nm to 250 $\mu$m. As the average hole depth of the depressions, a ten-point mean roughness $Rz_{jis}$ measured according to JIS B 0601 can be adopted.

The surface having a fine irregular structure with a specific periodic interval and/or specific depth (roughness) can be formed by a known physical, chemical, or electrochemical roughening method or a roughening method consisting of a combination of these. Particularly, from the viewpoint of quality stability or productivity of the roughened surface, a chemical roughening method is preferable. Examples of the chemical roughening method includes (i) immersion in an aqueous solution of an inorganic base such as caustic soda or an aqueous solution of an inorganic acid such as hydrochloric acid or nitric acid, (ii) immersion in an aqueous solution of an organic acid such as citric acid or malonic acid, (iii) immersion in a basic aqueous solution containing hydrazine, ammonia, and a water-soluble amine compound, and the like. The roughening method to be used may be appropriately selected or combined depending on the type of metal to be roughened, the joining strength required for the dissimilar material joined body, and the like.

After being roughened by the aforementioned method, the surface of the metal member 4 may be subjected to a chemical conversion treatment for the purpose of preventing corrosion. Particularly, in a case where the metal member 4 is a magnesium or magnesium alloy member, it is preferable to perform a chemical conversion treatment because such a metal member 4 is easily naturally oxidized by moisture and oxygen in the air.

Examples of the chemical conversion treatment include chromate treatment using an aqueous solution of chromic acid or potassium dichromate, a chemical conversion treatment using an aqueous solution of a manganese phosphate-based compound or a weakly acidic aqueous solution of potassium permanganate, and the like.

In addition to the chemical conversion treatment described above, a treatment using a water-soluble reducing agent such as hydroxylamine sulfate may be performed on the metal member 4 as a surface decolorization treatment. In a case where decolorization is performed, even though the coating film layer 5 (see Fig. 3) is adopted as a topcoat, it is possible to prevent the metal member 4 from looking unattractive due to the background color.

(Thermoplastic resin composition)

The thermoplastic resin composition contains a thermoplastic polyester resin (P) as a resin component.

It is preferable that the thermoplastic resin composition further contain one component or two or more components among other polymer components (Q), an additive (R), a filler (F), and the like.

The melting point Tm of the thermoplastic polyester resin (P) is equal to or higher than 250°C. The melting point Tm is preferably equal to or higher than 270°C, and more preferably equal to or higher than 280°C. The upper limit of the melting point Tm is not particularly limited. From the viewpoint of saving energy costs by reducing the heating

temperature for insert molding, the upper limit of Tm is for example 350°C, and preferably 335°C.

In a case where the melting point Tm is equal to or higher than 250°C, the molded product of the resin composition is inhibited from undergoing discoloration, deformation, or the like by melting and coming into contact with the metal member. It is preferable that the melting point be equal to or lower than 350°C, because then a thermoplastic polyester resin (A) is inhibited from decomposing when melting and coming into contact with the metal member.

For example, the melting point Tm of the thermoplastic polyester resin (P) is preferably in a range of 250°C to 350°C, more preferably in a range of 270°C to 350°C, and even more preferably in a range of 290°C to 335°C.

The melting point Tm of the thermoplastic polyester resin (P) can be measured by a differential scanning calorimeter (DSC) according to JIS K7121.

Specifically, about 5 mg of the resin is sealed in an aluminum pan for measurement and heated from room temperature to 340°C at 10°C/min by using DSC7 manufactured by PerkinElemer Co., Ltd. In order that the resin thoroughly melts, the resin is kept at 340°C for 5 minutes and then cool to 30°C at 10°C/min. The resin is left at 30°C for 5 minutes, and then subjected to second heating to 340°C at 10°C/min. The peak temperature (°C) of the second heating is adopted as the melting point Tm of the resin.

In a more preferable aspect, a crystallinity of the thermoplastic polyester resin (P) determined by a wide-angle X-ray diffraction profile is equal to or less than 50%, preferably equal to or less than 47%, and more preferably equal to or less than 45%. The lower limit of the crystallinity is not particularly limited (the lower limit may be 0%). In reality, the lower limit is equal to or more than 10%, and preferably equal to or more than 20%.

The crystallinity is calculated from the peak area ratio derived from the crystalline structure to the total diffraction peak area. For example, the crystallinity can be calculated from the peak area ratio derived from the crystalline structure measured using a wide-angle X-ray diffractometer (RINT2100: Rigaku Corporation) with a Cu radiation source.

In a case where the melting point Tm is equal to or higher than 250°C, and the crystallinity is the above numerical value, the plastic antenna cover 2 and the metal member 4 are more firmly joined together. In addition, the dimensional accuracy is further improved, and the electronic device housing tends to look attractive because the design thereof is so excellent that no step is found in the vicinity of the junction interface between the plastic antenna cover 2 and the metal member 4 even after a topcoat is formed by coating.

The thermoplastic polyester resin (P) is a polymer having a plurality of ester structures represented by -(C=O)-O- in a molecule. The structure ·type of the thermoplastic polyester resin (P) are not particularly limited as long as the melting point Tm is equal to or higher than 250°C.

From the viewpoint of further improving heat resistance, it is preferable that the thermoplastic polyester resin (P) contains a structural unit (a1) derived from an aromatic dicarboxylic acid and a structural unit (a2) derived from a diol having an alicyclic skeleton.

From the viewpoint of further improving the heat resistance of the thermoplastic polyester resin composition, it is preferable that the structural unit (a1) include at least a structural unit derived from a terephthalic acid-based monomer. The amount of the structural unit derived from a terephthalic acid-based monomer with respect to the total amount of the structural unit (a1) is preferably 30 to 100 mol%, more preferably 40 to 100 mol%, and even more preferably 60 to 100 mol%.

The structural unit (a1) may include a structural unit derived from an aromatic dicarboxylic acid-based monomer other than terephthalic acid. The amount of this structural unit with respect to the total amount of the structural unit (a1) is, for example, 0 to 70 mol%, preferably 0 to 60 mol%, and more preferably 0 to 40 mol%.

Examples of the terephthalic acid-based monomer include terephthalic acid and a terephthalic acid ester. Examples of the terephthalic acid ester include dimethyl terephthalate and the like.

Examples of the aromatic dicarboxylic acid-based monomer other than the terephthalic acid-based monomer include isophthalic acid, 2-methylterephthalate, naphthalenedicarboxylic acid, aromatic dicarboxylic acid esters of these (preferably alkyl esters of aromatic dicarboxylic acids having 1 to 4 carbon atoms), and the like.

The total amount of the structural unit derived from a terephthalic acid-based monomer and the structural unit derived from an aromatic dicarboxylic acid-based monomer other than terephthalic acid is preferably 100 mol% of the amount of structural units derived from dicarboxylic acid in the thermoplastic polyester resin (P). Here, depending on the desired characteristics, the thermoplastic polyester resin (P) may further contain a small amount of structural unit derived from an aliphatic dicarboxylic acid or a small amount of structural unit derived from a polyvalent carboxylic acid having 3 or more carboxylic acid groups in a molecule. The amount of these structural units with respect to the total amount of structural units in the thermoplastic polyester resin (P) is, for example, equal to or less than 10 mol%, and preferably equal to or less than 5 mol%.

The number of carbon atoms in the aliphatic dicarboxylic acid is not particularly limited. The number of carbon atoms is preferably 4 to 20, and more preferably 6 to 12. Examples of the aliphatic dicarboxylic acid include adipic acid, suberic acid, azelaic acid, sebacic acid, decanedicarboxylic acid, undecanedicarboxylic acid, dodecanedicarboxylic acid, and the like. Among these aliphatic dicarboxylic acids, adipic acid is preferable.

Examples of the polyvalent carboxylic acid include tribasic acids and polybasic acids such as trimellitic acid

and pyromellitic acid.

From the viewpoint of further improving the heat resistance of the thermoplastic polyester resin composition, it is preferable that the structural unit (a2) derived from a diol having an alicyclic skeleton have a structural unit derived from an alicyclic diol having 4 to 20 carbon atoms.

The structural unit (a2) can improve the heat resistance and reduce the water absorbency of the thermoplastic resin composition. Examples of the alicyclic diol include dialcohols having an alicyclic hydrocarbon skeleton with 4 to 20 carbon atoms, such as 1,3-cyclopentanediol, 1,3-cyclopentanedimethanol, 1,4-cyclohexanediol, 1,4-cyclohexanedimethanol, 1,4-cycloheptanediol, and 1,4-cycloheptanedimethanol, and the like. As the alicyclic diol, among these, from the viewpoint of further improving the heat resistance and further reducing water absorbency of the thermoplastic resin composition, ease of availability, and the like, a compound having a cyclohexane skeleton is preferable, and 1,4-cyclohexanedimethanol is more preferable.

The alicyclic diol includes isomers such as cis/trans-structures. From the viewpoint of further improving the heat resistance of the thermoplastic resin composition, it is preferable that the thermoplastic polyester resin (P) contains more structural units derived from an alicyclic dialcohol having a trans-structure.

Specifically, the cis/trans ratio of the structural unit derived from an alicyclic diol is preferably 50/50 to 0/100, and more preferably 40/60 to 0/100.

The thermoplastic polyester resin (P) may contain a structural unit derived from an aliphatic diol. In a case where the resin (P) contains such a structure, the melt fluidity of the thermoplastic resin composition can be further improved.

Examples of the aliphatic diol include ethylene glycol, trimethylene glycol, propylene glycol, tetramethylene glycol, neopentyl glycol, hexamethylene glycol, dodecamethylene glycol, and the like.

The thermoplastic polyester resin (P) may have, as the structural unit derived from a diol, either or both of the structural unit (a2) derived from a diol having an alicyclic skeleton and the structural unit derived from an aliphatic diol.

In the structural unit derived from a diol, the content of the structural unit (a2) derived from a diol having an alicyclic skeleton (preferably a component unit derived from a diol having a cyclohexane skeleton and more preferably a component unit derived from cyclohexanedimethanol) is preferably 30 to 100 mol%, and the content of the component unit derived from an aliphatic diol is preferably 0 to 70 mol%.

The proportion of the structural unit (a2) derived from a diol having an alicyclic skeleton is more preferably 50 to 100 mol%, and even more preferably 60 to 100 mol%.

The proportion of structural unit derived from an aliphatic diol is more preferably 0 to 50 mol%, and even more preferably 0 to 40 mol%.

The total amount of the structural unit (a2) derived from a diol having an alicyclic skeleton and the structural unit derived from an aliphatic diol is preferably 100 mol% with respect to the total amount of structural units derived from a diol in the thermoplastic polyester resin (P) . Here, depending on the desired characteristics, the thermoplastic polyester resin (P) may further contain a small amount of structural unit derived from an aromatic diol.

Examples of the aromatic diol include bisphenol A, hydroquinone, 2,2-bis(4-β-hydroxyethoxyphenyl) propane, EO adducts of bisphenol A, and the like.

The proportion of the structural unit derived from an aromatic diol in all structural units of the thermoplastic polyester resin (P) can be, for example, equal to or less than 10 mol%, and preferably equal to or less than 5 mol%.

The intrinsic viscosity [η] of the thermoplastic polyester resin (P) is preferably 0.3 to 1.5 dl/g. In a case where the intrinsic viscosity is in the above range, the thermoplastic resin composition exhibits higher fluidity during molding.

The intrinsic viscosity [η] of the thermoplastic polyester resin (P) can be adjusted to the above range by adjusting the molecular weight of the thermoplastic polyester resin (P) and the like.

For details of the method for measuring the intrinsic viscosity [η], see Examples that will be described later.

As described above, the thermoplastic resin composition may contain other polymer components (Q) in addition to the thermoplastic polyester resin (P).

According to the knowledge of the inventors of the present invention, in a case where the thermoplastic resin composition contains other resins, particularly the joining strength between the metal member and the resin composition after the annealing treatment following joining hardly decreases, and/or the joining strength is higher than that before the annealing treatment.

Those other polymer components (Q) are preferably one kind or two or more kinds selected from the group consisting of a copolymer having a structural unit derived from an olefin and a structural unit having a cyclic oxyhydrocarbon structure (hereinafter, also called "copolymer (D)"), and one or more polymers (E) selected from the group consisting of an ethylene·α-olefin copolymer (E1), a polybutylene terephthalate (E2), a polycarbonate (E3), and an isophthalic acid-modified polycyclohexylenedimethylene terephthalate (E4) (hereinafter, also called "polymer (E)").

Particularly, in a case where both the copolymer (D) and polymer (E) are used, it is easy to suppress a decrease in the joining strength between the metal member and the resin composition after the annealing treatment following joining.

According to the knowledge of the inventors of the present invention, particularly in a case where either or both

of the polybutylene terephthalate (E2) and polycarbonate (E3) are used as the polymer (E), even though the joined body is immersed in a chemical liquid for surface modification such as micro-arc oxidation, the joining strength hardly decreases. Presumably, this is because the incorporation of the polybutylene terephthalate (E2) and/or the polycarbonate (E3) into the thermoplastic resin composition may reduce the crystallinity of the thermoplastic resin composition. Presumably, because the low crystallinity reduce the solidification speed of the resin, the molten resin may easily permeate deep into the irregular structure of the metal, and the joining strength may increase accordingly. Presumably, as a result, the permeation of a chemical liquid during surface modification may be suppressed, and thus the decrease in the joining strength may be suppressed.

The copolymer (D) has a structural unit derived from an olefin and a structural unit having a cyclic oxyhydrocarbon structure. The copolymer (D) may further have a structural unit derived from an α,β-unsaturated carboxylic acid ester. In a case where the resin composition contains the copolymer (D), a decrease in joining strength between the metal member and the resin composition having been heat-treated after being joined to the metal member is suppressed.

Examples of the structural unit derived from an olefin constituting the copolymer (D) include structural units derived from ethylene, propylene, 1-butene, 1-hexene, 1-octene, 1-decene, and the like. Among these, a structural unit derived from ethylene is preferable.

Examples of the structural unit having a cyclic oxyhydrocarbon structure constituting the copolymer (D) include a structural unit derived from an α,β-unsaturated carboxylic acid glycidyl ester, and the like. Examples of the α,β-unsaturated carboxylic acid glycidyl ester include an acrylic acid glycidyl ester, a methacrylic acid glycidyl ester, and the like. Among these, a methacrylic acid glycidyl ester is preferable.

Examples of structural unit derived from an α,β-unsaturated carboxylic acid ester constituting the copolymer (D) include structural units derived from acrylic acid esters including methyl acrylate, ethyl acrylate, butyl acrylate, and the like and methacrylic acid esters including methyl methacrylate, ethyl methacrylate, and the like. Among these, a structural unit derived from methyl acrylate is preferable.

In addition, the structural unit derived from an α,β-unsaturated carboxylic acid ester may have a cyclic oxyhydrocarbon structure such as a glycidyl ester group. Specifically, the copolymer (D) may be a copolymer containing a structural unit derived from an olefin and a structural unit derived from an α,β-unsaturated carboxylic acid glycidyl ester.

Examples of specific aspects of the copolymer (D) include a copolymer containing an ethylene unit, a methyl acrylate unit, and a structural unit derived from glycidyl methacrylate, such as an ethylene·methyl acrylate·glycidyl methacrylate copolymer represented by the following structural formula.

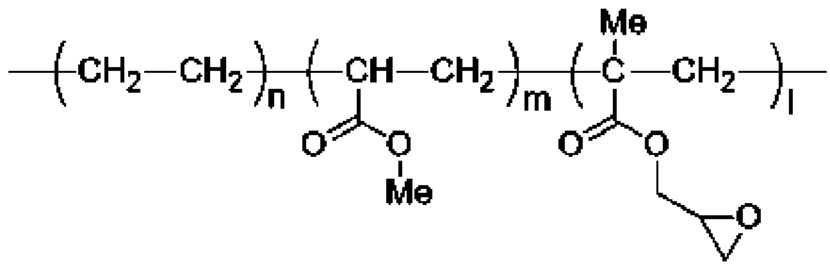

In the above structural formula, n, m, and 1 each independently represent a positive integer.

In the copolymer (D) represented by the above structural formula, the content of the structural unit derived from ethylene with respect to the total amount (100% by mass) of the ethylene unit, the methyl acrylate unit, and the structural unit derived from glycidyl methacrylate is preferably 30% to 99% by mass, and more preferably 50% to 95% by mass.

The copolymer (E1) is preferably an ethylene-based copolymer consisting of ethylene and at least one or more α-olefins having 3 to 20 carbon atoms. "Ethylene-based" means, for example, that the proportion of the structural unit derived from ethylene in all structural units is equal to or more than 50 mol%, and preferably equal to or more than 60 mol%.

The copolymer (E1) has a function of suppressing variation in joining strength between the metal member and the resin composition in a case where the thermoplastic resin composition is joined to the metal member.

Examples of the α-olefins having 3 to 20 carbon atoms include propylene, 1-butene, 1-pentene, 1-hexene, 1-heptene, 1-octene, 1-decene, 4-methyl-1-pentene, and the like. Among these, propylene, 1-butene, 1-hexene, and 1-octene are preferable. Each of these α-olefins may be used alone, or two or more of these α-olefins may be used in combination.

In the copolymer (E1), the proportion of the structural unit derived from an α-olefin having 3 to 20 carbon atoms is preferably 5 to 30 mol%, more preferably 8 to 30 mol%, and even more preferably 10 to 25 mol%.

The copolymer (E1) may be a random copolymer or block copolymer of ethylene and an α-olefin having 3 to 20 carbon atoms . The copolymer (E1) is preferably a random copolymer.

The density of the copolymer (E1) is preferably 0.85 to 0.95 g/cm$^3$, and more preferably 0.87 to 0.93 g/cm$^3$.

In addition, the melt flow rate (MFR) of the copolymer (E1) measured under a load of 2.16 kg at 190°C according to JIS K 7210: 1999 is preferably 0.5 to 100 g/10 min, and more preferably 1 to 80 g/10 min. In a case where the melt flow rate of the copolymer (E1) is in this range, it is easy for the thermoplastic resin composition to exhibit higher fluidity during molding.

The usable polybutylene terephthalate (E2) is not particularly limited. As the polybutylene terephthalate (E2), a polymer containing a structural unit derived from dimethyl terephthalate or high-purity terephthalic acid and a structural unit derived from 1,4-butanediol can be used without particular limitations. Examples of commercially available products thereof include NOVADURAN manufactured by Mitsubishi Engineering-Plastics Corporation, TPS-PBT manufactured by Toray Plastics Precision Co., Ltd., DURANEX 500FP manufactured by Polyplastics Co., Ltd., and the like.

The usable polycarbonate (E3) is not particularly limited. Examples of commercially available products thereof include PANLITE L-1225Y manufactured by TEIJIN LIMITED, TARFLON manufactured by Idemitsu Kosan Co., Ltd., SD POLYCA manufactured by Sumika Polycarbonate Limited., WONDERLITE manufactured by CHIMEI, PANLITE manufactured by TEIJIN LIMITED, NOVAREX and IUPILON manufactured by Mitsubishi Engineering-Plastics Corporation, and the like.

The isophthalic acid-modified polycyclohexylenedimethylene terephthalate (E4) is obtained by substituting some (not all) of terephthalic acids or derivatives thereof of raw material monomers of polycyclohexylenedimethylene terephthalate manufactured by polycondensation of terephthalic acids or derivatives thereof and cyclohexylenedimethylene diol with isophthalic acids or derivatives thereof. The ratio of isophthalic acids or derivatives thereof to the total amount of dicarboxylic acids or derivative thereof as raw materials (the total amount of terephthalic acids or derivatives thereof and isophthalic acids or derivatives thereof) is usually less than 50 mol%.

Examples of commercially available products of the isophthalic acid-modified polycyclohexylenedimethylene terephthalate (E4) include DURASTAR (trade name), brand name: DS2000 manufactured by Eastman Chemical Company, and the like.

In a case where the copolymer (D) and the polymer (E) are used in combination as other components (Q), the mass ratio of copolymer (D):polymer (E) ((D):(E)) is about 1:0.1 to 1:0.5.

In a case where one component or a combination of two or more components selected from the group consisting of the copolymer (D), the polybutylene terephthalate (E2), the polycarbonate (E3), and the isophthalic acid-modified polycyclohexylenedimethylene terephthalate (E4) is used as other components (Q), the mass ratio of copolymer (D):(E2) to (E4) ((D):{(E2) + (E3) + (E4)}) is, for example, 1:1 to 1:10, preferably 1:2 to 1:10, and more preferably 1:3 to 1:8.

As described above, the thermoplastic resin composition may contain an additive (R).

Examples of the additive (R) include known additives such as an antioxidant (such as phenols, amines, sulfurs, or phosphoric acids), a heat-resistant stabilizer (such as a lactone compound, vitamin E, hydroquinones, copper halide, or an iodine compound), a photostabilizer (such as benzotriazoles, triazines, benzophenones, benzoates, hindered amines, or oxanilides), a flame retardant (such as a bromine-, chlorine-, phosphorus-, or antimony-based flame retardant or an inorganic flame retardant), a lubricant, a fluorescent whitening agent, a plasticizer, a thickener, an antistatic agent, a mold release agent, a pigment, a crystal nucleating agent, a foaming agent, and a foaming aid.

From the viewpoint of adjusting the difference in linear expansion coefficient between the metal member 4 and the plastic antenna cover 2 or improving the mechanical strength of the antenna cover 2, the thermoplastic resin composition may further contain a filler (F).

As the filler (F), for example, one kind or two or more kinds can be selected from the group consisting of glass fiber, carbon fiber, carbon particles, clay, talc, silica, mineral, and cellulose fiber. Among these, one kind or two or more kinds selected from glass fiber, carbon fiber, talc, and mineral are preferable.

The amount of each component with respect to the total amount (100% by mass) of the thermoplastic resin composition can be set as below.

- Thermoplastic polyester resin (P): 40% to 80% by mass, preferably 50% to 70% by mass, and more preferably 55% to 65% by mass
- Other polymer components (Q): 1% to 20% by mass, preferably 2% to 15% by mass, and more preferably 5% to 15% by mass
- Additive (R): 0.1% to 10% by mass, preferably 0.1% to 5% by mass, and more preferably 0.2% to 3% by mass
- Filler (F): 5% to 50% by mass, preferably 10% to 50% by mass, and more preferably 20% to 40% by mass

In a case where the amount of each component is appropriately adjusted, the plastic antenna cover 2 and the metal member 4 are more firmly joined. Furthermore, the dimensional accuracy can be further improved. In addition, it is possible to fully suppress the occurrence of a gap at the junction interface between the plastic antenna cover 2 and the metal member 4. As a result, in a case where the coating film layer 5 is provided thereon, it is easy to obtain a dissimilar material joined body having excellent design in which substantially no step is formed in the vicinity of the junction 7.

The properties of the thermoplastic resin composition are not particularly limited. The thermoplastic resin composition may be a mixture of the particles of each of the above components, a preliminarily kneaded composition, or the like. In addition, the components may be mixed together and put into a hopper of a device during insert molding (injection molding).

The thermoplastic resin composition may contain, for example, a thermoplastic polyester resin having a melting point Tm equal to or higher than 50°C and less than 250°C, an amorphous resin, or the like, in addition to the components described above. A typical example of the thermoplastic polyester resin is polybutylene terephthalate, and a typical example of the amorphous resin is polycarbonate. In a case where the composition contains these resins, generally, the amount of the resins is about equal to or less than 50% of the amount of the thermoplastic polyester resin (P).

(Coating film layer)

In the present embodiment, it is preferable that a continuous coating film layer 5 be formed in a part or the entirety of the surface including the junctional site between the metal member 4 and the plastic antenna cover 2. More preferably, a continuous coating film layer 5 is formed on the entire outer surface side including the junctional site. The coating film layer 5 usually has a function of protecting and decorating (improving the design) the electronic device housing.

As described above, within the outer surface (vicinity of the point P in Fig. 3) of the junction 7 between the metal member 4 and the plastic antenna cover 2 and the vicinity thereof, no engagement step (trace) occurs, or the size of an engagement step can be minimized. Therefore, the occurrence of a step on the surface of the coating film layer 5 is also suppressed. In a preferred aspect, no step is found in the coating film layer 5 formed at the junction 7 between the metal member 4 and the plastic antenna cover 2, which results in excellent design.

The average thickness of the coating film layer 5 is for example 10 to 500 μm, and preferably 20 to 300 μm.

The main components constituting the coating film layer 5 are, for example, a film-forming substance, a pigment, an additive, and the like.

Examples of the film-forming substance include known resins. Examples of the resins include polyethylene, polypropylene, a vinyl chloride resin, an acrylic resin, a polycarbonate resin, a polystyrene resin, a polyurethane resin, a phenol resin, an epoxy resin, and the like.

Examples of the pigment include carbon black, titanium white, and the like. In addition, depending on the desired design and the like, one known pigment or two or more known pigments can be used.

Examples of the additive include a plasticizer, a flame retardant, a lubricant, a stabilizer, a foaming agent, and the like.

Furthermore, in order to make the coating film layer 5 glossy, metal fine particles such as aluminum powder or silver powder may be added.

<Manufacturing method of electronic device housing>

The electronic device housing of the present embodiment is preferably manufactured by performing the following Steps 1 to 5 in this order.

(Step 1) a step of preparing the metal member 4.

(Step 2) a step of joining and integrating the metal member 4 and a thermoplastic resin composition containing a thermoplastic polyester resin having a melting point Tm equal to or higher than 250°C by insert molding so as to manufacture a dissimilar material joined body consisting of the metal member and a plastic antenna cover.

(Step 3) a step of annealing the dissimilar material joined body at 180°C to 350°C for 1 to 30 minutes so as to convert the dissimilar material joined body into a heat-treated dissimilar material joined body.

(Step 4) a step of performing an oxidation treatment on a surface of at least a portion of the metal member of the heat-treated dissimilar material joined body, the portion to which the plastic antenna cover is not joined, by at least one method selected from the group consisting of anodic oxidation, micro-arc oxidation, and a chemical conversion treatment so as to obtain a surface-modified dissimilar material joined body.

(Step 5) a step of forming the coating film layer 5 in at least a region of the surface-modified dissimilar material joined body, the region including a junctional portion between the metal member and the plastic antenna cover.

Step 1 is a step of preparing the metal member 4. As described above, at least the junction 7 on the surface of the metal member 4 that is joined to the plastic antenna cover 2 may be surface-treated. From the viewpoint of further increasing the joining strength between the metal member 4 and the thermoplastic resin composition, it is preferable that at least the junction 7 of the metal member 4 be roughened.

Step 2 is a step of joining and integrating the metal member 4 and the thermoplastic resin composition containing the thermoplastic polyester resin (P) having a melting point Tm equal to or higher than 250°C by insert molding so as

to manufacture a dissimilar material joined body consisting of the metal member and plastic.

"Insert molding" is a type of injection molding. Specifically, this is a molding technique of inserting a metal member in advance in a mold and then performing molding by injecting a molten resin into the mold so that the metal member and the resin are integrated.

Specifically, in the procedure of Step 2, first, the metal member 4 is installed in a mold for injection molding. Next, a melt of the thermoplastic resin composition containing the thermoplastic polyester resin (P) is molded by being injected into the mold through an injection molding machine. The melt of the thermoplastic resin composition joined to the metal member 4 is cooled, thereby obtaining a dissimilar material joined body consisting of the metal member 4 and the plastic antenna cover 2 that are integrated.

In a case where a fine irregular structure is formed on the surface of the metal member 4, it is preferable that the thermoplastic resin composition be injection-molded so that the composition is in contact with the fine irregular structure.

The inner surface temperature of the mold during injection and dwelling is preferably equal to or higher than the glass transition temperature of the thermoplastic resin composition, and more preferably 5°C to 100°C higher than the glass transition temperature.

For example, at a cylinder temperature of 280°C to 350°C and an injection speed of 10 to 30 mm/sec, the melt of the thermoplastic resin composition is injected into the mold in which the roughened metal member 4 is disposed. At this time, the dwelling pressure can be set to 70 to 120 MPa, and the dwelling time can be set to 10 to 30 seconds.

Thereafter, the mold is opened and released so that a dissimilar material joined body can be obtained.

In the present embodiment, known injection foam molding or high-speed heat cycle molding (heat & cool molding) that rapidly heats and cools a mold may be used in combination with insert molding (injection molding).

Step 3 is a step of annealing the dissimilar material joined body obtained in Step 2 at 180°C to 350°C for 1 to 30 minutes so as to convert the dissimilar material joined body into a heat-treated dissimilar material joined body.

Annealing is also called a precipitation hardening treatment, a stress relieving annealing treatment, or the like. Annealing is usually performed to relieve residual stress caused by heating operations such as forging, casting, cold working, welding, machining, and injection molding or to correct deformation caused by dimensional change. The annealing temperature varies with the type of metal constituting the metal member 4, the type of resin constituting the plastic antenna cover 2, and the like. The annealing temperature is generally 180°C to 350°C, preferably 190°C to 330°C, more preferably 200°C to 300°C, and particularly preferably 200°C to 280°C. The annealing time is usually 1 to 30 minutes, and preferably 5 to 20 minutes.

Annealing is performed, for example, by heating the dissimilar material joined body on a temperature-controlled hot plate under the atmospheric pressure or in a pressurized state. Then, if necessary, heating is stopped in a pressurized state or sometimes in a state where the shape of the dissimilar material joined body is physically restrained, and the dissimilar material joined body is slowly cooled.

Step 4 is a step of performing an oxidation treatment on a surface of at least a portion of the metal member of the heat-treated dissimilar material joined body obtained in Step 3, the portion to which plastic is not joined, by at least one method selected from the group consisting of anodic oxidation, micro-arc oxidation (MAO oxidation), and a chemical conversion treatment so as to obtain a surface-modified dissimilar material joined body.

It is preferable to perform Step 4 because the surface of the metal member 4 can be more stable in the air by this step. Furthermore, by this treatment, nm-order fine irregular holes are formed within the surface of the metal member. The formation of such holes also contributes to the improvement of adhesion with the coating film layer to be formed in the subsequent Step 5.

As the anodic oxidation treatment, known methods can be used without limitations.

The MAO oxidation is usually performed by applying a high voltage in an alkaline electrolytic solution in which an alkali metal salt of phosphoric acid or pyrophosphoric acid is dissolved.

Examples of the chemical conversion treatment include a chromate treatment in which the dissimilar material joined body is immersed in chromium, potassium dichromate, or the like so that the entire surface thereof is covered with a thin layer of trivalent chromium, a treatment in which the dissimilar material joined body is immersed in an aqueous solution of a manganese salt containing phosphoric acid so that the entire surface thereof is covered with a thin layer of a manganese phosphate-based compound, a treatment method of immersing the dissimilar material joined body in an aqueous solution of weakly acidic potassium permanganate so that the entire surface thereof is covered with a thin layer of manganese dioxide, and the like.

These oxidation treatments may be selectively performed only on the metal portion to which plastic is not joined or may be performed on the entire dissimilar material joined body. From the viewpoint of increasing the treatment speed, these treatments are usually carried out in a state where the entire dissimilar material joined body is immersed in a treatment solution.

Step 5 is a step of forming the coating film layer 5 in at least a region of the surface-modified dissimilar material joined body, the region including the junction 7 between the metal member 4 and the plastic antenna cover 2.

The components constituting the coating film layer 5 are as described above.

The components constituting the coating film layer 5 are dissolved or dispersed in a general-purpose solvent (organic solvent), such as ethanol, acetone, an aliphatic hydrocarbon, or an aromatic hydrocarbon, so that a coating material is obtained, and the surface of the surface-modified dissimilar material joined body is coated with the coating material. Then, if necessary, the coating material is heated (or naturally dried) so that a volatile component such as a solvent is distilled away, thereby forming the coating film layer 5.

As the coating method, known methods such as brush coating, roller coating, dip coating, and spray coating can be used without limitations. In forming the coating film layer 5, a primer layer as an underlayer may be provided.

For example, in the electronic device housing obtained as described above, the crystallinity of the plastic antenna cover determined by a wide-angle X-ray diffraction profile is preferably equal to or less than 50%, more preferably equal to or less than 47%, and even more preferably equal to or less than 45%. The lower limit of the crystallinity is not particularly limited (the lower limit may be 0%). In reality, the lower limit is equal to or more than 10%, and preferably equal to or more than 20%.

The method for determining the crystallinity is as described above. Therefore, it will not be described again.

It is considered that the low crystallinity of the plastic antenna cover in the final electronic device housing means that the molten resin easily permeates deep into the irregular structure of the metal during the manufacturing stage of the electronic device housing. Presumably, as a result, in the electronic device housing including the plastic antenna cover having a low crystallinity, joining strength between the metal member and the plastic antenna cover may be excellent, and the joining strength may tend not to easily decrease.

The crystallinity of the plastic antenna cover can be adjusted by adjusting the crystallinity of the thermoplastic polyester resin (P) as a raw material or adjusting the temperature conditions of Step 2 or 3 described above and the like.

The electronic device housing of the present embodiment can be used in various fields. For example, the electronic device housing can be used in the field of notebook PC as a body unit or a display unit of notebook PC; in the field of mobile devices as a housing or a frame body for mobile phones or smartphones; and in the field of camera as a cover or a mirror box for a digital single-lens reflex camera.

<Metal-resin composite>

Hitherto, "electronic device housing" including a metal member and a plastic antenna cover that are joined and integrated by insert molding has been described. However, considering the excellent joining strength retention rate before and after the annealing treatment, the metal-resin joining technique described in the present specification is not limited to the electronic device housing and can be preferably used for various uses. Specific examples of "various fields" include home appliances, vehicles, building materials, daily necessities, and the like. It goes without saying that "various fields" are not limited to these. For example, the metal-resin joining technique can also be preferably used for insulating parts of bus bars, terminals, and the like, in addition to the electronic device housing.

Especially, a metal-resin composite composed of a magnesium alloy member and a resin member that are joined and integrated (the resin member mentioned herein is a molded product of a thermoplastic resin composition containing a thermoplastic polyester resin having a melting point Tm equal to or higher than 250°C) is preferably applicable to various fields not limited to electronic device housings.

The magnesium alloy in the above "metal-resin composite composed of a magnesium alloy member and a resin member that are joined and integrated" is as described in the section of <Electronic device housing>.

Details of the resin member in the above "metal-resin composite composed of a magnesium alloy member and a resin member that are joined and integrated" are as described above in (Thermoplastic resin composition) of <Electronic device housing> and the like.

As the joining and integrating method in the above "metal-resin composite composed of a magnesium alloy member and a resin member that are joined and integrated", for example, it is possible to appropriately use the method such as insert molding or annealing described in <Manufacturing method of electronic device housing>.

Hitherto, the uses of the electronic device housing according to the present embodiment have been described. However, these are merely examples of uses of the present embodiment, and the present invention can be used for various other uses.

[Example]

Hereinafter, the present invention will be more specifically described with reference to examples. The scope of the present invention is not limited to the examples.

1. Preparation of raw material resin of thermoplastic resin composition

(Synthesis of thermoplastic polyester resin (P))

Tetrabutyl titanate (0.0037 parts by mass) was added to a mixture of 106.2 parts by mass of dimethyl terephthalate and 94.6 parts by mass of 1,4-cyclohexanedimethanol (cis/trans ratio: 30/70), and the mixture was heated to 260°C from 150°C for 3 hours and 30 minutes so that a transesterification reaction occurred.
At the end of the transesterification reaction, 0.0165 parts by mass of manganese acetate·tetrahydrate dissolved in 1,4-cyclohexanedimethanol was added, and then 0.0299 parts by mass of tetrabutyl titanate was introduced into the reaction solution so that a polycondensation reaction occurred.
During the polycondensation reaction, while the pressure was being slowly reduced to 1 Torr for 85 minutes, the temperature was raised to a predetermined polymerization temperature of 300°C. The temperature and the pressure were kept, and at a point in time when a stirring torque reached a predetermined level, the reaction was terminated.
The obtained polymer had an intrinsic viscosity [η] of 0.6 dl/g and a melting point Tm of 290°C.
Furthermore, the obtained polymer had a crystallinity of 47% that was calculated from the peak area ratio derived from the crystalline structure measured using a wide-angle X-ray diffractometer (RINT2100: Rigaku Corporation) with a Cu radiation source.
Hereinafter, this polymer will be described as a thermoplastic polyester resin (p) in some cases.

(Preparation of copolymer (D))

As the copolymer (D), an epoxy group-containing ethylene methacrylate copolymer (LOTADER GMA AX8900 manufactured by Arkema (LOTADER is a registered trademark of the same company) was prepared.
Hereinafter, this copolymer will be described as a copolymer (d) in some cases.

(Synthesis of ethylene·α-olefin copolymer (E1))

A glass flask thoroughly purged with nitrogen was filled with 0.63 mg of bis(1,3-dimethylcyclopentadienyl)zirconium dichloride, and 1.57 ml of a methylaluminoxane solution in toluene (Al: 0.13 mmol/L) and 2.43 ml of toluene were further added thereto, thereby obtaining a catalyst solution.
Hexane (912 mL) and 320 mL of 1-butene were introduced into a stainless steel autoclave with an internal volume of 2 L thoroughly purged with nitrogen, and the internal temperature of the system was raised to 80°C. Subsequently, 0.9 mmol of triisobutylaluminum and 2.0 mL of the above catalyst solution (0.0005 mmol as Zr) were pushed into the flask using ethylene so that polymerization was initiated.
Ethylene was continuously supplied so that the total pressure was kept at 8.0 $kg/cm^2$-G, and polymerization was carried out at 80°C for 30 minutes. A small amount of ethanol was introduced into the system so that the polymerization was terminated, and then unreacted ethylene was purged. The obtained solution was poured into a large excess of methanol so that white solids were precipitated.
The white solids were collected by filtration and dried overnight under reduced pressure, thereby obtaining an ethylene·1-butene copolymer in the form of white solids. The ethylene·1-butene copolymer had a 1-butene content of 14 mol%, a density of 870 $kg/m^3$, and MFR (JIS K 7210: 1999, 190°C, load of 2,160 g) of 3.6 g/10 min.
Hereinafter, this ethylene ·1-butene copolymer will be described as a copolymer (e) in some cases.

(Preparation of polybutylene terephthalate (E2))

CRASTIN (trade name), brand: S600F10 NC010 manufactured by DuPont was prepared.

(Preparation of polycarbonate (E3))

IUPILON (trade name), brand: H-3000, manufactured by Mitsubishi Engineering-Plastics Corporation was prepared.

(Preparation of isophthalic acid-modified polycyclohexylenedimethylene terephthalate (E4))

DURASTAR (trade name), brand name: DS2000 manufactured by Eastman Chemical Company was prepared.
The intrinsic viscosity [η] and the melting point Tm of each the above resins were measured by the following methods.

[Intrinsic viscosity [η]]

Each resin (0.5 g) was dissolved in 50 ml of a 96.5% by mass aqueous sulfuric acid solution. By using Ubbelohde viscometer, the flow time of the obtained solution was measured in seconds under the condition of 25°C ± 0.05°C, and the intrinsic viscosity [η] was calculated based on the following formula.

$$[\eta] = \eta_{SP}/(C\ (1 + 0.205\eta_{SP}))$$

[η]: Intrinsic viscosity (dl/g)
$\eta_{SP}$: Specific viscosity [$\eta_{SP} = (t - t_0)/t_0$]
C: Sample concentration (g/dl)
t: Flow time (sec) of sample solution
to: Flow time (sec) of blank sulfuric acid

[Melting point Tm]

The melting point Tm was measured according to the stipulation of JIS K 7121.

Specifically, about 5 mg of a resin was sealed in an aluminum pan for measurement and heated from room temperature to 340°C at 10°C/min by using DSC7 manufactured by PerkinElemer Co., Ltd. In order that the resin thoroughly melted, the resin was kept at 340°C for 5 minutes and then cooled to 30°C at 10°C/min. The resin was left at 30°C for 5 minutes, and then subjected to second heating to 340°C at 10°C/min. The peak temperature (°C) of the second heating was adopted as the melting point Tm of the resin.

2. Preparation of metal member

A magnesium plate (having a thickness of 2 mm) of alloy number AZ31B was cut in a length of 45 mm and a width of 18 mm or in a length of 50 mm and a width of 10 mm (the 45 mm x 18 mm plate was for preparing the following dissimilar material joined body A, and the 50 mm x 10 mm plate was for preparing the following dissimilar material joined body B).

The surface of the cut magnesium plate was roughened by the method described in Experimental Example 1 of International Publication No. WO2008/133096.

The surface roughness of the roughened magnesium plate was measured using a surface roughness measuring device "SURFCOM 1400D" manufactured by TOKYO SEIMITSU CO., LTD. As a result, it was confirmed that the ten-point mean roughness Rz was in a range of 2 to 3 μm, and the average length RSm of the roughness curve element was in a range of 90 to 110 μm.

3. Preparation and characteristic evaluation of dissimilar material joined body (simulated electronic device housing)

First, the evaluation method will be described.

[Joining strength]

The joining strength of the dissimilar material joined body was evaluated by tensile shear strength. Specifically, a special jig is attached to the tensile tester model 1323 manufactured by Aikoh Engineering Co., Ltd., and then the dissimilar material joined body A (details will be described later) schematically shown in Fig. 4 is installed in the tester. At room temperature (23°C), the metal member and the resin member of the dissimilar material joined body A are pulled in opposite directions under the conditions of an inter-chuck distance of 60 mm and a tensile speed of 10 mm/min. At this time, the load under which a metal member 103 and a resin member 105 are broken and separated is measured.

In order to reduce the influence of the variation of the measured values, the tensile shear strengths of 5 dissimilar material joined bodies A to which the same thermoplastic resin composition is joined are measured, and the average thereof is adopted as the joining strength. The standard deviation is also calculated to ascertain the variation of the measured values.

"Dissimilar material joined body A" is in the form schematically shown in Fig. 4. More specifically, the dissimilar material joined body A consists of the magnesium alloy member (represented by the reference sign 103 in Fig. 4) prepared in the above section 2. and the resin member 105 joined to one end (hatched portion in Fig. 4 having a size of 5 mm × 10 mm) thereof.

[Topcoat suitability of coating film layer (whether or not coating film layer has step)]

In order to visually evaluate topcoat suitability of the coating film layer, that is, to visually evaluate whether a step is found in the junctional site in a case where the coating film layer is formed on the surface of the dissimilar material joined body, a test piece joined by butting (hereinafter, also described as "dissimilar material joined body B") schematically shown in Fig. 5 is prepared. The dissimilar material joined body B is obtained by joining the metal member 103 (made of a magnesium alloy) and the resin member 105 so that these are butted against each other (the junctional portion has a size of 2 mm × 10 mm).

For the metal member 103, surface modification (oxidation treatment) and coating film formation are performed as described in the following (1) and (2).

(1) First, according to the description in Kurimoto Technical Report No. 64, pp. 38 to 43, micro-arc oxidation (MAO) is performed on the whole surface of the dissimilar material joined body B.

(2) Then, the dissimilar material joined body B is brush-coated with UNITECT 20 (manufactured by Kansai Paint Co., Ltd.), which is a commercially available acryl-modified epoxy resin, and then dried at 80°C for 10 minutes so that a coating film layer is formed.

Whether or not a step is found in the coating film layer is checked as follows.

An LED light is radiated to the boundary region between the resin member 105 and the metal member 103 of the dissimilar material joined body B at an oblique angle of 45°, and whether or not a step is on the coating surface is visually checked.

[Example 1]

The following components were put into an injection molding machine and melt-kneaded, thereby obtaining a thermoplastic resin composition.

- 63.8 parts by mass of thermoplastic polyester resin (p)
- 2.0 parts by mass of copolymer (d)
- 0.16 parts by mass of phenolic antioxidant (manufactured by BASF SE, MP-X, also described as "antioxidant 1" hereinbelow)
- 0.34 parts by mass of phosphoric acid-based antioxidant (manufactured by ADEKA Corporation, ADEKA STAB (registered trademark) PEP-36, also described as "antioxidant 2" hereinbelow)
- 3.0 parts by mass of styrene-modified ethylene-based polymer as a crystal nucleating agent (intrinsic viscosity [$\eta$]: 0.03 dl/g, melt viscosity at 140°C: 40 mPa·s, weight average molecular weight Mw: 930, molecular weight distribution Mw/Mn: 1.8, melting point: 107°C)
- 0.7 parts by mass of talc
- 30.0 parts by mass of glass fiber (having a diameter of 10 $\mu$m)

At a cylinder temperature of 320°C and an injection speed of 25 mm/sec, the aforementioned molten thermoplastic resin composition was injected into a mold in which the metal member roughened in the above section 2. was disposed, and injection molding (insert molding) was performed under the conditions of a dwelling pressure of 100 MPa and a dwelling time of 15 seconds, thereby obtaining 15 dissimilar material joined bodies A.

Five samples were randomly selected from these dissimilar material joined bodies A, and the joining strength (average of the 5 samples) was determined according to the above method. The joining strength was 1,560 N, and the standard deviation was 66 N.

Thereafter, the remaining 10 dissimilar material joined bodies were annealed at 240°C for 1 hour, and then slowly cooled to room temperature. After slow cooling, for 5 random dissimilar material joined bodies A (having been heat-treated), the joining strength (average of 5 samples) was determined in the same manner. The joining strength was 1,276N, and the standard deviation was 78 N.

The joining strength retention rate before and after the annealing treatment was 82%.

In addition, any one of the dissimilar material joined bodies A (having undergone annealing treatment) was selected, and the crystallinity of the resin member portion thereof was determined using a wide-angle X-ray diffraction profile (the measuring device and the like were the same as those used for measuring the crystallinity of the thermoplastic polyester resin (P)). The determined crystallinity was 36%.

Furthermore, in order to evaluate the topcoat suitability, 5 dissimilar material joined bodies B were obtained using the thermoplastic resin composition having the same makeup as described above under the same injection molding (insert molding) conditions as above. The obtained dissimilar material joined bodies B were annealed at 240°C for 1

hour, and then slowly cooled to room temperature.

Then, as described in the section of [Topcoat suitability of coating film layer (whether or not coating film layer has step)] described above, the entirety of each of the dissimilar material joined bodies B was subjected to micro-arc oxidation (MAO), and then the coating film layer was formed. Thereafter, whether a step occurred in the coating film layer was checked.

As a result, no step was checked in all of the 5 samples.

[Example 2]

The dissimilar material joined body A was prepared and evaluated in the same manner as in Example 1, except that the following components were put into an injection molding machine and melt-kneaded to prepare a thermoplastic resin composition to be used.

- 58.8 parts by mass of thermoplastic polyester resin (p)
- 5.0 parts by mass of copolymer (d)
- 2.0 parts by mass of copolymer (e)
- 0.16 parts by mass of antioxidant 1
- 0.34 parts by mass of antioxidant 2
- 3.0 parts by mass of styrene-modified ethylene-based polymer as a crystal nucleating agent (same as in Example 1)
- 0.7 parts by mass of talc
- 30.0 parts by mass of glass fiber (having a diameter of 10 $\mu$m)

The dissimilar material joined body A had an average joining strength of 1,340 N (standard deviation: 10 N) before the annealing treatment, and had an average joining strength of 1,340 N (standard deviation: 22 N) after the annealing treatment. The joining strength retention rate before and after the annealing treatment was 100%.

In addition, any one of the dissimilar material joined bodies A having undergone the annealing treatment was selected, and the crystallinity of the resin member portion thereof was determined using a wide-angle X-ray diffraction profile (the measuring device and the like were the same as those used for measuring the crystallinity of the thermoplastic polyester resin (P)). The determined crystallinity was 35%.

Furthermore, in order to evaluate the topcoat suitability, 5 dissimilar material joined bodies B were obtained using the thermoplastic resin composition having the same makeup as described above under the same injection molding (insert molding) conditions as above. The obtained dissimilar material joined bodies B were annealed at 240°C for 1 hour, and then slowly cooled to room temperature.

Then, as described in the section of [Topcoat suitability of coating film layer (whether or not coating film layer has step)] described above, the entirety of each of the dissimilar material joined bodies B was subjected to micro-arc oxidation (MAO), and then the coating film layer was formed. Thereafter, whether a step occurred in the coating film layer was checked.

As a result, no step was checked in 4 samples, and a slight step was checked only in 1 sample.

[Examples 3 to 5]

The preparation and evaluation of the dissimilar material joined bodies A and B (including the micro-arc oxidation (MAO), the formation of a coating film layer, and the like) were performed in the same manner as in Example 1, except that the following components were put into an injection molding machine and melt-kneaded to prepare a thermoplastic resin composition to be used.

(Example 3)

- 53.8 parts by mass of thermoplastic polyester resin (p)
- 2.0 parts by mass of copolymer (d)
- 10 parts by mass of polybutylene terephthalate (as described above)
- 0.16 parts by mass of antioxidant 1
- 0.34 parts by mass of antioxidant 2
- 3.0 parts by mass of styrene-modified ethylene-based polymer as a crystal nucleating agent (same as in Example 1)
- 0.7 parts by mass of talc
- 30.0 parts by mass of glass fiber (having a diameter of 10 $\mu$m)

(Example 4)

- 53.8 parts by mass of thermoplastic polyester resin (p)
- 2.0 parts by mass of copolymer (d)
- 10 parts by mass of polycarbonate (as described above)
- 0.16 parts by mass of antioxidant 1
- 0.34 parts by mass of antioxidant 2
- 3.0 parts by mass of styrene-modified ethylene-based polymer as a crystal nucleating agent (same as in Example 1)
- 0.7 parts by mass of talc
- 30.0 parts by mass of glass fiber (having a diameter of 10 μm)

(Example 5)

- 53.8 parts by mass of thermoplastic polyester resin (p)
- 2.0 parts by mass of copolymer (d)
- 10 parts by mass of isophthalic acid-modified polycyclohexylenedimethylene terephthalate (as described above)
- 0.16 parts by mass of antioxidant 1
- 0.34 parts by mass of antioxidant 2
- 3.0 parts by mass of styrene-modified ethylene-based polymer as a crystal nucleating agent (same as in Example 1)
- 0.7 parts by mass of talc
- 30.0 parts by mass of glass fiber (having a diameter of 10 μm)

In all of Examples 3 to 5, the joining strength retention rate before and after the annealing treatment (evaluation using the dissimilar material joined body A) was 100%.

Furthermore, in all of Examples 3 to 5, the crystallinity of the resin member portion of the dissimilar material joined body A after the annealing treatment was determined by the wide-angle X-ray diffraction profile in the same manner as in Examples 1 and 2. In all of Examples 3 to 5, the determined crystallinity was equal to or less than 50% (about 30% to 40%).

Furthermore, in all of Examples 3 to 5, the topcoat suitability of the coating film layer evaluated using the dissimilar material joined body B was excellent, and no step was checked in all of the 5 dissimilar material joined bodies B prepared in the examples.

[Comparative Example 1]

The preparation of the dissimilar material joined body A, the annealing treatment, and the joining strength evaluation were performed in the same manner as in Example 1, except that 65.8 parts by mass of a polybutylene terephthalate resin (manufactured by Toray Industries, Inc., TORAYCON 1401X06, melting point Tm: 224°C) was used instead of 63.8 parts by mass of the thermoplastic polyester resin (p), and the copolymer (d) was not used.

The dissimilar material joined body A before the annealing treatment had a joining strength (average of 5 samples) of 1,250 N. On the other hand, after the annealing treatment, the resin member 105 in the dissimilar material joined body A was seriously deformed, and it was impossible to measure the joining strength.

In Comparative Example 1, the dissimilar material joined body B for checking a step was not manufactured.

[Summary and review of evaluation results]

In Examples 1 to 5, the metal member 103 and the resin member 105 were firmly joined, and the joining force was maintained even after the annealing treatment (240°C for 1 hour).

Particularly, in Examples 2 to 5, the joining force was maintained 100% before and after the annealing treatment. Presumably, the component corresponding to the polymer (E) may bring about such an effect.

In Examples 1 to 5, the topcoat suitability of the coating film layer was also excellent. That is, in a case where the coating film layer was formed on the surface of the dissimilar material joined body consisting of the metal member 103 and the resin member 105, the occurrence of a step in the coating film layer was suppressed. Presumably, this is because the junction does not fracture during annealing or because cracks (dents, gaps, or depressions) inducing a step do not occur or are suppressed from spreading even in a case where the entirety of the heat-treated dissimilar

material joined body is immersed in a chemical liquid for the subsequent surface oxidation treatment. It is considered that the excellent heat resistance and chemical resistance of the plastic antenna portion of the dissimilar material joined body, the high joining strength between the metal member and the junction, the high airtightness/watertightness, and the like may have brought about the above effect.

On the other hand, in Comparative Example 1 in which a thermoplastic resin composition containing a thermoplastic polyester resin having a Tm lower than 250°C was used, deformation occurred due to annealing after insert molding.

[Additional evaluation: joining strength after micro-arc oxidation (MAO)]

The joining strength of the dissimilar material joined body B subjected to micro-arc oxidation (MAO) in Examples 1 to 5 was evaluated. As a result of the evaluation, particularly excellent joining strength was obtained in Example 3 (using polybutylene terephthalate) and Example 4 (using polycarbonate) (the joining strength decreased little after micro-arc oxidation).

This application claims a priority based on Japanese Patent Application No. 2019-080746 filed on April 22, 2019, the entire content of which is incorporated into the present specification.

REFERENCE SIGNS LIST

- 1: notebook PC
- 1a: body unit
- 1b: display unit
- 2: plastic antenna cover
- 3: antenna element
- 4: metal member
- 5: coating film layer
- 7: junction
- 103: metal member
- 105: resin member

## Claims

1. An electronic device housing comprising:

   a metal member; and
   a plastic antenna cover,
   wherein the metal member and the plastic antenna cover are joined and integrated by insert molding, and
   the plastic antenna cover is a molded product of a thermoplastic resin composition containing a thermoplastic polyester resin having a melting point Tm equal to or higher than 250°C.

2. The electronic device housing according to claim 1,
   wherein a crystallinity of the plastic antenna cover determined by a wide-angle X-ray diffraction profile is equal to or less than 50%.

3. The electronic device housing according to claim 1 or 2,
   wherein the thermoplastic polyester resin contains a structural unit derived from an aromatic dicarboxylic acid-based monomer and a structural unit derived from a diol having an alicyclic skeleton.

4. The electronic device housing according to claim 3,
   wherein the aromatic dicarboxylic acid-based monomer is terephthalic acid.

5. The electronic device housing according to any one of claims 1 to 4,
   wherein a content of the thermoplastic polyester resin (P) in the thermoplastic resin composition is 40% to 80% by mass.

**6.** The electronic device housing according to any one of claims 1 to 5, wherein the thermoplastic resin composition contains other polymer components (Q) in addition to the thermoplastic polyester resin (P).

**7.** The electronic device housing according to claim 6, wherein a content of the other polymer components (Q) in the thermoplastic resin composition is 1% to 20% by mass.

**8.** The electronic device housing according to claim 6 or 7, wherein the other polymer components (Q) include a copolymer (D) having a structural unit derived from an olefin and a structural unit having a cyclic oxyhydrocarbon structure.

**9.** The electronic device housing according to claim 8, wherein the other polymer components (Q) further include one or more polymers (E) selected from the group consisting of an ethylene·$\alpha$-olefin copolymer (E1), polybutylene terephthalate (E2), polycarbonate (E3), and isophthalic acid-modified polycyclohexylenedimethylene terephthalate (E4).

**10.** The electronic device housing according to claim 9, wherein a mass ratio of the copolymer (D) : the polymer (E) is 1:0.1 to 1:0.5.

**11.** The electronic device housing according to claim 9 or 10, wherein a mass ratio of the copolymer (D) : the polybutylene terephthalate (E2), the polycarbonate (E3) and the isophthalic acid-modified polycyclohexylenedimethylene terephthalate (E4) is 1:1 to 1:10.

**12.** The electronic device housing according to any one of claims 1 to 11, wherein the metal member is one kind selected from the group consisting of magnesium or a magnesium alloy, aluminum or an aluminum alloy, titanium or a titanium alloy, and copper or a copper alloy.

**13.** The electronic device housing according to any one of claims 1 to 12, wherein an anticorrosive surface modifying film is formed on at least a portion of a surface of the metal member, the portion to which the plastic antenna cover is not joined.

**14.** A manufacturing method of an electronic device housing, comprising:

(step 1) preparing a metal member;
(step 2) joining and integrating the metal member and a thermoplastic resin composition containing a thermoplastic polyester resin having a melting point Tm equal to or higher than 250°C by insert molding so as to manufacture a dissimilar material joined body consisting of the metal member and a plastic antenna cover;
(step 3) annealing the dissimilar material joined body at 180°C to 350°C for 1 to 30 minutes so as to convert the dissimilar material joined body into a heat-treated dissimilar material joined body;
(step 4) performing an oxidation treatment on a surface of at least a portion of the metal member of the heat-treated dissimilar material joined body, the portion to which the plastic antenna cover is not joined, by at least one method selected from the group consisting of anodic oxidation, micro-arc oxidation, and a chemical conversion treatment so as to obtain a surface-modified dissimilar material joined body; and
(step 5) forming a coating film layer in at least a region of the surface-modified dissimilar material joined body, the region including a junctional portion between the metal member and the plastic antenna cover,

wherein the steps 1 to 5 are performed in this order.

**15.** A metal-resin composite comprising:

a magnesium alloy member; and
a resin member,
wherein the magnesium alloy member and the resin member are joined and integrated, and
the resin member is a molded product of a thermoplastic resin composition containing a thermoplastic polyester resin having a melting point Tm equal to or higher than 250°C.

Fig. 1

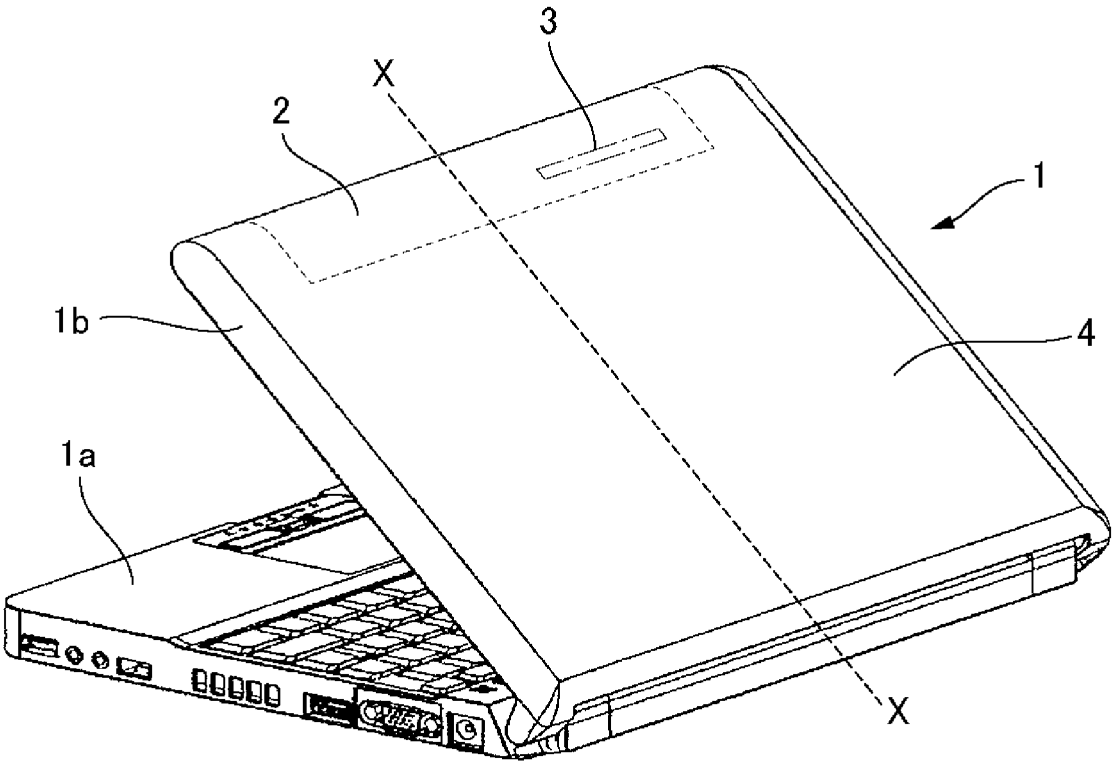

Fig. 2

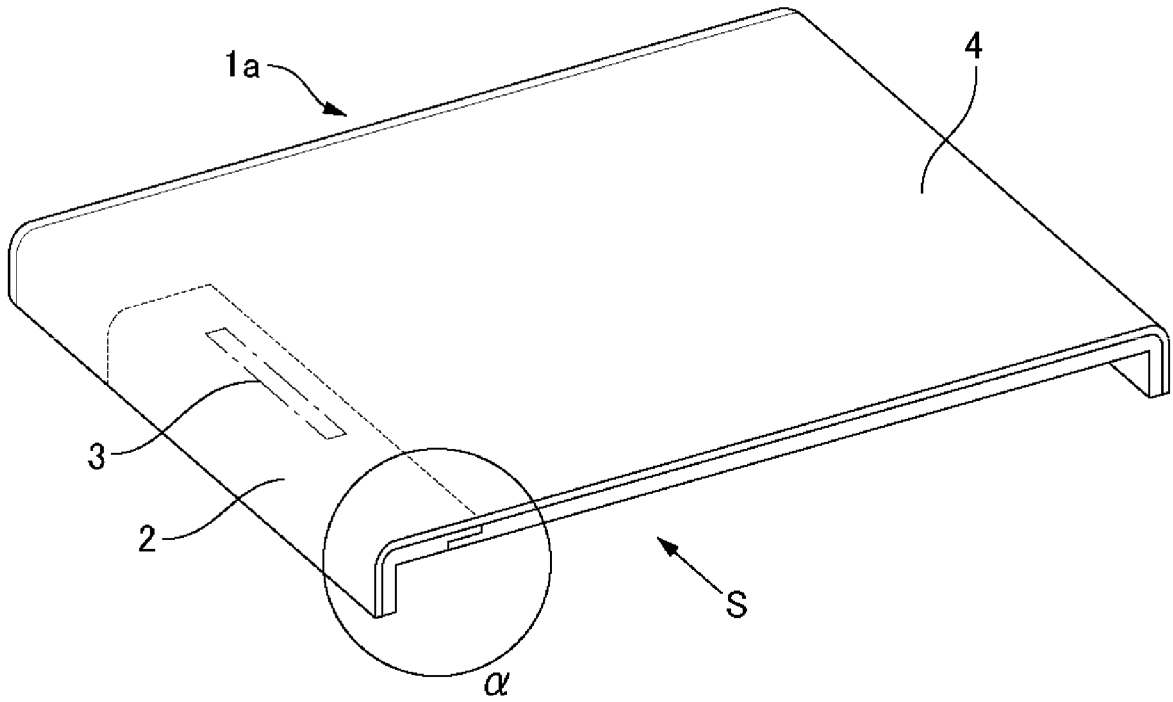

Fig. 3

FIG. 3

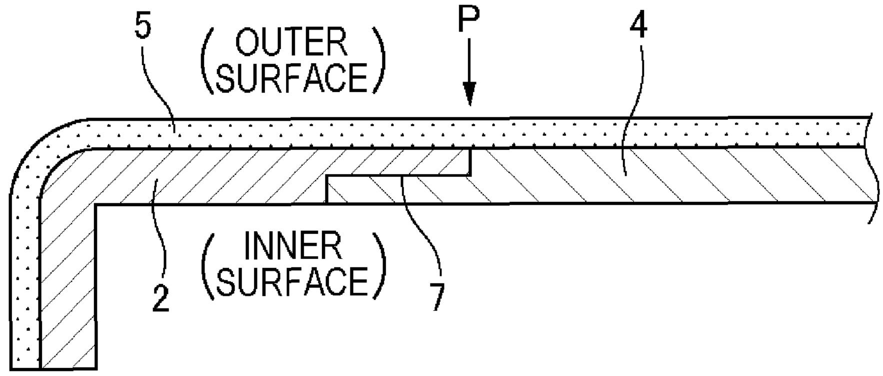


Fig. 4

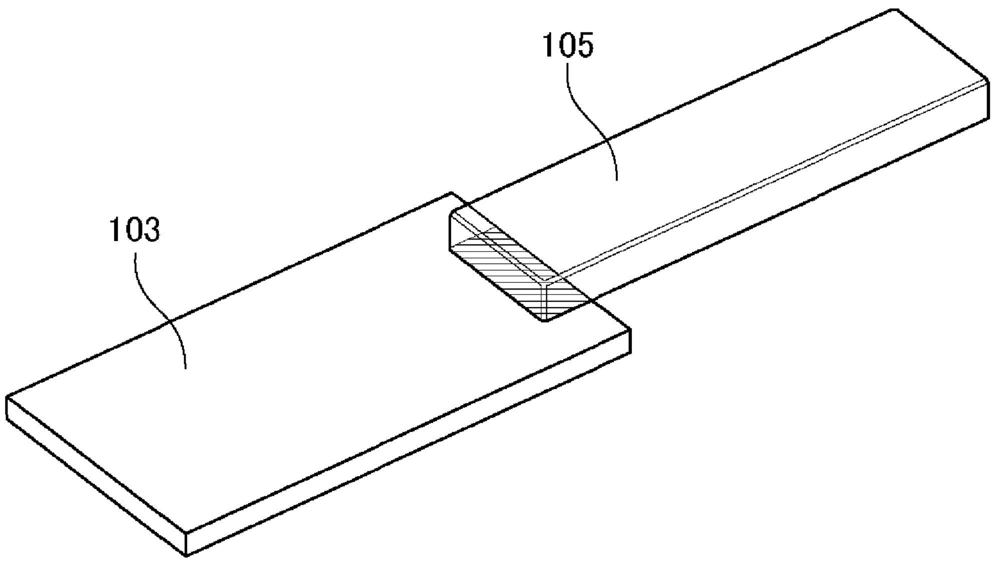

Fig. 5

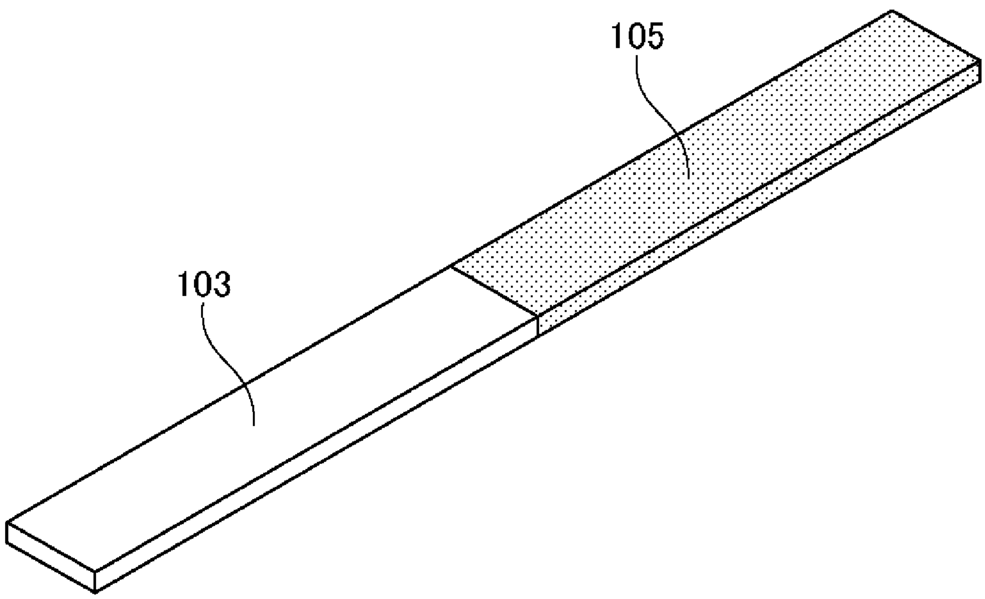

## INTERNATIONAL SEARCH REPORT

International application No.
PCT/JP2020/017156

**A. CLASSIFICATION OF SUBJECT MATTER**
B21D 47/04(2006.01)i; B21D 53/00(2006.01)i; B29C 45/14(2006.01)i; H05K 5/02(2006.01)i
FI: H05K5/02 J; B21D47/04; B21D53/00 D; B29C45/14
According to International Patent Classification (IPC) or to both national classification and IPC

**B. FIELDS SEARCHED**

Minimum documentation searched (classification system followed by classification symbols)
B21D47/04; B21D53/00; B29C45/14; H05K5/02

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2017-199803 A (HITACHI MAXELL, LTD.) 02.11.2017 (2017-11-02) paragraphs [0016]-[0018], [0032], fig. 1 | 15 |
| A | paragraphs [0016]-[0018], [0032], fig. 1 | 1-14 |
| Y | WO 2018/056433 A1 (TORAY INDUSTRIES, INC.) 29.03.2018 (2018-03-29) paragraphs [0014]-[0019], [0049]-[0050] | 1, 2, 6, 12, 13, 15 |
| A | paragraphs [0014]-[0019], [0049]-[0050] | 3-5, 7-11, 14 |
| Y | JP 2010-282493 A (TOSHIBA CORP.) 16.12.2010 (2010-12-16) paragraphs [0016]-[0017], [0021]-[0023], fig. 1 | 1, 2, 6, 12, 13, 15 |
| A | paragraphs [0016]-[0017], [0021]-[0023], fig. 1 | 3-5, 7-11, 14 |
| Y | JP 2010-80515 A (TOSHIBA CORP.) 08.04.2010 (2010-04-08) paragraphs [0005]-[0008] | 13 |
| A | paragraphs [0005]-[0008] | 1-12, 14, 15 |
| A | US 2016/0079663 A1 (SAMSUNG ELECTRONICS CO., LTD.) 17.03.2016 (2016-03-17) entire text, all drawings | 1-15 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>07 July 2020 (07.07.2020) | Date of mailing of the international search report<br>21 July 2020 (21.07.2020) |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

International application No.
PCT/JP2020/017156

C (Continuation). DOCUMENTS CONSIDERED TO BE RELEVANT

| Category* | Citation of document, with indication, where appropriate, of the relevant passages | Relevant to claim No. |
|---|---|---|
| A | JP 2006-346980 A (SUMITOMO ELECTRIC INDUSTRIES, LTD.) 28.12.2006 (2006-12-28) paragraphs [0029]-[0030] | 1-15 |

Form PCT/ISA/210 (continuation of second sheet) (January 2015)

**INTERNATIONAL SEARCH REPORT**
Information on patent family members

International application No.
PCT/JP2020/017156

| Patent Documents referred in the Report | Publication Date | Patent Family | Publication Date |
|---|---|---|---|
| JP 2017-199803 A | 02 Nov. 2017 | US 2019/0069400 A1 paragraphs [0022]-[0024], [0039], fig. 1<br>EP 3451802 A1<br>CN 109076692 A<br>KR 10-2019-0002476 A | |
| WO 2018/056433 A1 | 29 Mar. 2018 | US 2019/0237862 A1 paragraphs [0023]-[0028], [0058]-[0059]<br>EP 3518633 A1<br>SG 11201901161R A<br>CN 109691248 A<br>KR 10-2019-0060981 A<br>TW 201817586 A | |
| JP 2010-282493 A | 16 Dec. 2010 | (Family: none) | |
| JP 2010-80515 A | 08 Apr. 2010 | (Family: none) | |
| US 2016/0079663 A1 | 17 Mar. 2016 | KR 10-2016-0031306 A entire text, all drawings | |
| JP 2006-346980 A | 28 Dec. 2006 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010282493 A
- JP 2011156587 A
- WO 2008133096 A
- JP 2019080746 A


### Non-patent literature cited in the description


- *Kurimoto Technical Report,* vol. 64, 38-43